# EUROPEAN PATENT APPLICATION

(11) **EP 4 819 512 A2**
(43) Date of publication of application: **07.10.2026**
(21) Application number: 26169045.7
(22) Date of filing: 30.03.2026
(51) Int. Cl.: H04B 10/50, G02B 6/42, H01S 5/42

(54) **OPTICAL TRANSMITTER WITH REDUNDANT LIGHT SOURCE**

(30) Priority: 01.04.2025 US 202563781692 P; 23.03.2026 US 202619574978
(71) Applicant: II-VI Delaware, Inc., Wilmington, DE 19890 (US)
(72) Inventor: Nelson, Stephen, Wilmington, 19890 (US); Kocot, Chris, Wilmington, 19890 (US)
(74) Representative: Bosch Jehle Patentanwaltsgesellschaft mbH

(57) **Abstract**

An optical link includes an optical transmitter with redundant or spare light sources for transmitting optical signals over an optical fiber of the optical link. The optical transmitter uses a first light source to generate and transmit optical signals to an optical receiver via an optical fiber. In response to detecting faulty operation of the first light source, the optical transmitter ceases using the first light source to transmit optical signals to the optical receiver and switch to a second or spare light source to transmit optical signals to the optical receiver via the same optical fiber. In this manner, the optical transmitter may continue to reliably transmit optical signals to the optical receiver over the same optical fiber even in the presence of a faulty light source.

## Description

### CROSS-REFERENCE TO RELATED APPLICATIONS

This application claims the benefit of U.S. Provisional Application No. 63/781,692, filed April 1, 2025, the disclosure of which is hereby incorporated by reference herein in its entirety.

### TECHNICAL FIELD

Aspects of the present disclosure relate to optical communications and optical transmitters for optical communications.

### BACKGROUND

Optical communication networks include optical transmitters which generate and transmit optical signals to optical transmitters via respective optical fibers. In particular, such optical transmitters may include a light source such as an LED or laser diode that generates an optical signal which is injected into a respective optical fiber of the optical communication network. However, for various reasons, the light source of the optical transmitter may cease operating or cease operating sufficiently to reliably transmit data via its respective optical fiber. In such situations, data transfers may cease over the respective optical fiber until which time a technician may manually replace the faulty component.

Further limitations and disadvantages of conventional and traditional approaches will become apparent to one of skill in the art, through comparison of such approaches with some aspects of the present disclosure as set forth in the remainder of the present application with reference to the drawings.

### BRIEF SUMMARY OF THE DISCLOSURE

Shown in and/or described in connection with at least one of the figures, and set forth more completely in the claims, are optical transmitters with multiple light sources. Such optical transmitters may use a first light source to transmit optical signals to an optical receiver via an optical fiber. In response to operation of the first light source becoming faulty, the optical transmitter may switch operation to a second light source and continue to reliably transmit optical signals to the optical receiver using the same optical fiber even in the presence of a faulty light source.

These and other advantages, aspects, and novel features of the present disclosure, as well as details of illustrated embodiments thereof, will be more fully understood from the following description and drawings.

### BRIEF DESCRIPTION OF THE DRAWINGS

Various features and advantages of the present disclosure may be more readily understood with reference to the following detailed description taken in conjunction with the accompanying drawings, wherein like reference numerals designate like structural elements.
FIG. 1A depicts an optical link comprising an optical transmitter with redundant or spare light sources in accordance with various aspects of the present disclosure.
FIG. 1B depicts another optical link comprising an optical transmitter with redundant or spare light sources in accordance with various aspects of the present disclosure.
FIG. 2 depicts details of an embodiment of the optical transmitter of FIG. 1A and/or FIG. 1B.
FIG. 3 depicts details of another embodiment of the optical transmitter of FIG. 1A and/or FIG. 1B.
FIG. 4 depicts an example light source sparing process of the optical link of FIG. 1A and/or FIG. 1B.

### DESCRIPTION

Aspects of the present disclosure are directed to an optical link in which its optical transmitter includes redundant or spare light sources for transmitting optical signals over an optical fiber of the optical link. For example, the optical transmitter may use a first light source to generate and transmit optical signals to an optical receiver via an optical fiber. In response to detecting faulty operation of the first light source, the optical transmitter may cease using the first light source to transmit optical signals to the optical receiver and may switch to a second or spare light source to transmit optical signals to the optical receiver via the same optical fiber. In this manner, the optical transmitter may continue to reliably transmit optical signals to the optical receiver over the same optical fiber even in the presence of a faulty light source.

The figures illustrate a general manner of construction. Descriptions and details of well-known features and techniques may be omitted to avoid unnecessarily obscuring the present disclosure. In addition, elements in the drawing figures are not necessarily drawn to scale. For example, the dimensions of some of the elements in the figures may be exaggerated relative to other elements to help improve understanding of the examples discussed in the present disclosure. The same reference numerals in different figures denote the same elements.

The term "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

The terms "comprises," "comprising," "includes," and/or "including," are "open ended" terms and specify the presence of stated features, but do not preclude the presence or addition of one or more other features.

The terms "first," "second," *etc.* may be used herein to describe various elements, and these elements should not be limited by these terms. These terms are only used to distinguish one element from another. Thus, for example, a first element discussed in this disclosure could be termed a second element without departing from the teachings of the present disclosure.

Unless specified otherwise, the term "coupled" may be used to describe two elements directly contacting each other or describe two elements indirectly connected by one or more other elements. For example, if element A is coupled to element B, then element A may be directly contacting element B or indirectly connected to element B by an intervening element C. Similarly, the terms "over" or "on" may be used to describe two elements directly contacting each other or describe two elements indirectly connected by one or more other elements.

Also, any numerical range recited herein is intended to include all sub-ranges subsumed therein. For example, a range of "1 to 10" is intended to include any and all sub-ranges between and including the recited minimum value of 1 and the recited maximum value of 10, that is, all sub-ranges beginning with a minimum value equal to or greater than 1 and ending with a maximum value equal to or less than 10, and all sub-ranges in-between, *e.g.*, 1 to 6.3, or 5.5 to 10, or 2.7 to 6.1.

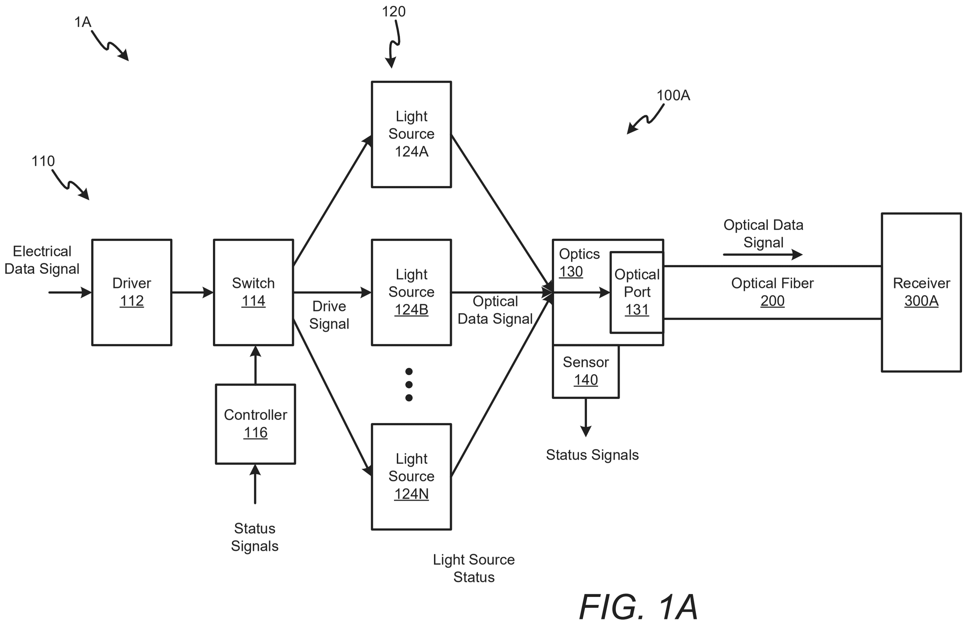

Referring now to FIG. 1A, an optical link 1A is shown in accordance with various aspects of the present disclosure. As shown, the optical link 1A may include an optical transmitter 100A, an optical fiber 200, and an optical receiver 300A. The optical fiber 200 may couple the optical transmitter 100A to the optical receiver 300A so as to permit the optical transmitter 100A to transmit optical signals to the optical receiver 300A.

The optical transmitter 100A may include control circuitry 110, a semiconductor light emitting device 120, optical elements 130, and an optical sensor 140. The semiconductor light emitting device 120 may include light sources 124A-124N used to generate optical signals transmitted to the optical receiver 300A via the optical fiber 200.

In general, the light sources 124A-124N may provide the optical transmitter 100A with light source sparing or light source redundancy. In particular, the optical transmitter 100A may drive the optical fiber 200 via a selective one of the light sources 124A-124N and may switch to a different one or the light sources 124A-124N in response to detecting a potential issue with the currently selected light source 124A-124N. In this manner, the optical transmitter 100A may continue to transmit optical signals to the optical receiver 300A via the optical fiber 200 even in the presence of one or more degraded, failed, and/or otherwise faulty light sources of the light sources 124A-124N.

To this end, the control circuitry 110 of the optical transmitter 100A may include a driver 112, a switch 114, and a controller 116. The driver 112 may receive an electrical data signal and provide the switch 114 with an electrical drive signal suitable for driving a light source 124A-124N. In particular, the electrical drive signal may cause the selected light source 124A-124N to generate optical signals representative of the electrical data signal. To this end, the driver 112 may amplify, balance, condition, and/or otherwise generate the electrical drive signal so as to provide the switch 114 with an electrical drive signal suitable for driving a selected one of the light sources 124A-124N.

The controller 116 may generate one or more control signals that cause the switch 114 to direct the electrical drive signal to a selected one or the light sources 124A-124N. In particular, the controller 116 may receive one or more status signals that are representative of one or more operating characteristics of the currently selected light source 124A-124N. As long as the selected light source 124A-124N continues to operate within tolerances, the controller 116 may continue to generate control signals that cause the switch 114 to direct the electrical drive signal to the selected light source 124A-124N of the semiconductor light emitting device 120. However, in response to detecting faulty operation of the selected light source 124A-124N, the controller 116 may generate one or more control signals that cause the switch 114 to direct the electrical drive signals to a different one of the light sources 124A-124N.

The optical elements 130 may receive an optical signal from the selected light source 124A-124N. The optic elements 130 may further inject the received optical signal into the optical fiber 200 coupled to an optical port 131 of the optical elements 130. The optical elements 130 may also direct a tapped portion of the optical signal to the optical sensor 140.

The optical sensor 140 may receive the tapped portion of the optical signal and provide the controller 116 with electrical status signals that are representative of optical power and/or other operating characteristics of the monitored optical signal. Based on such electrical status signals, the controller 116 may assess whether the currently selected light source 124A-124N is faulty and/or otherwise not performing to specification. Further, based on such assessment, the controller 116 may elect to switch to a different one of the light sources 124A-124N. In this manner, the optical transmitter 100A may continue to provide the optical fiber 200 with a suitable optical signal even if one or more of the light sources 124A-124N ceases to operate and/or ceases to reliably operate.

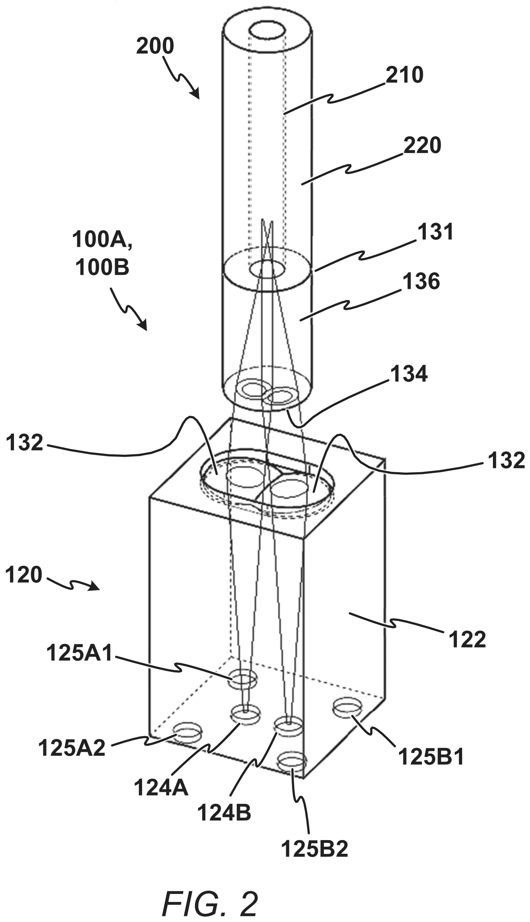

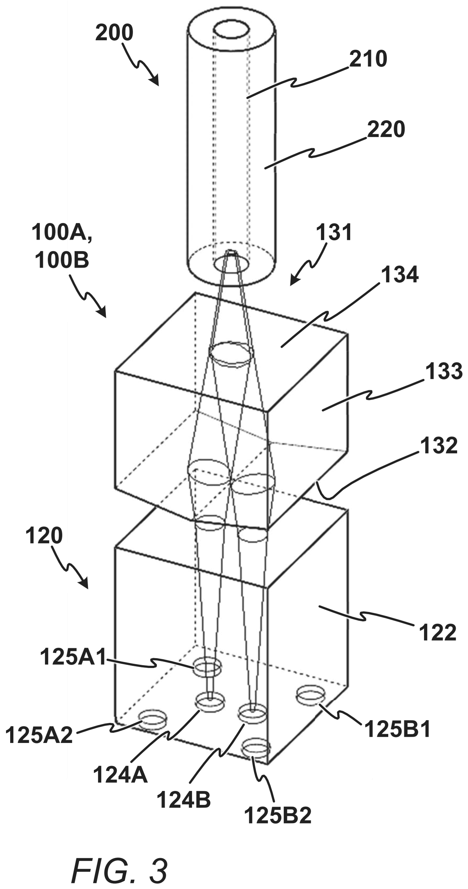

In various embodiments, the semiconductor light emitting device 120 may be implemented using solid-state light emitting devices such as light emitting diodes, laser diodes, vertical cavity surface emitting laser (VCSEL) diodes, vertical external cavity surface emitting laser (VECSEL) diodes, edge emitting laser diodes, and/or other solid-state light emitting devices. In such embodiments, the semiconductor light emitting device 120 may comprise a semiconductor substrate 122 (See, e.g., FIGS. 2 and 3) that is common to each of the light sources 124A-124N. Moreover, such light sources 124A-124N may emit light directly into air from a front or cavity side of the semiconductor substrate 122. Alternatively, the light emitted by the light sources 124A-124N may pass from the front or cavity side of the semiconductor substrate 122, through the semiconductor substrate 122, and out a back side of the semiconductor substrate 122 as shown in FIGS. 2 and 3.

In some embodiments, the optical sensor 140 may be integrated into the same semiconductor substrate 122 as the light source 124A-124N. In other embodiments, the optical sensor 140 may be implemented as a separate component. In some embodiments, the optical transmitter 100A may include a separate optical sensor 140 for each light source 124A-124N, thus providing a one-to-one relationship between optical sensors 140 and light sources 124A-124N. However, during typical operation, the controller 116 may cause only a single selected light source 124A-124N of the semiconductor light emitting device 120 to emit a beam at a given time. In such embodiments, a single optical sensor 140 may be sufficient to monitor the operating status of the currently selected light source 124A-124N.

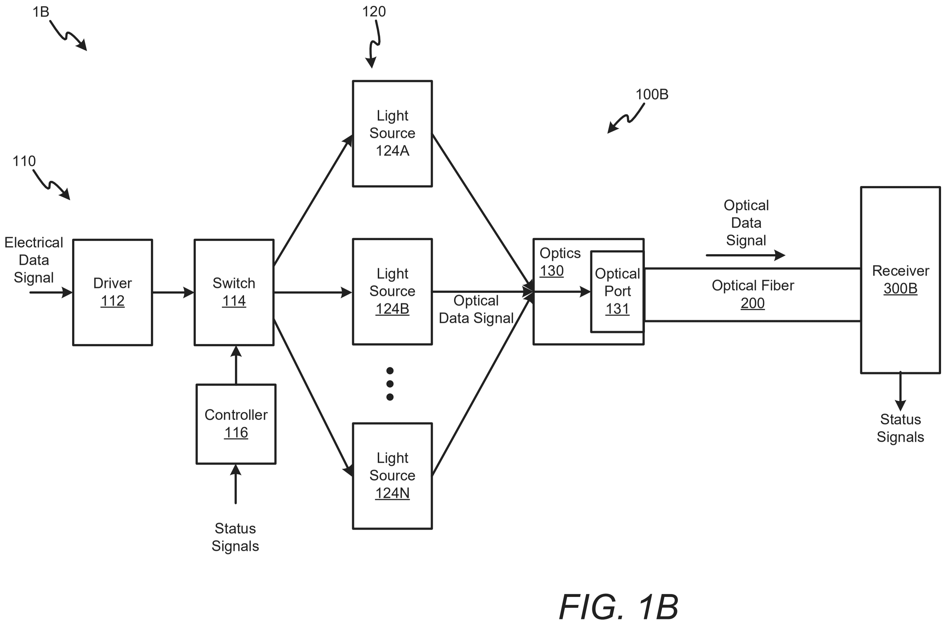

Referring now to FIG. 1B, an optical link 1B is shown in accordance with various aspects of the present disclosure. Similar to the optical link 1A of FIG. 1A, the optical link 1B may include an optical transmitter 100B, an optical fiber 200, and an optical receiver 300B. In general, the optical transmitter 100B and the optical receiver 300B of FIG. 1B may be implemented in a manner similar to the optical transmitter 100A and the optical receiver 300A of FIG. 1A. However, the optical transmitter 100A of FIG. 1A includes one or more optical sensors 140, which monitor the operation of the selected optical light source 124A-124N. The optical transmitter 100B of FIG. 1B, however, may lack such an optical sensor. Instead, the optical receiver 300B of FIG. 1B may provide the optical transmitter 100B with status information for the currently selected light source 124A-124N. In particular, the optical receiver 300B of FIG. 1B may include optical sensors that monitor the optical power and/or other characteristics of the optical signal received via the optical fiber 200. The optical receiver 300B may then provide such monitored characteristics to the optical transmitter 100B.

In particular, the optical receiver 300B may, in some embodiments, provide such characteristics via the same optical fiber 200 via which it receives the optical signal from the optical transmitter 100B. In such embodiments, the optical signal 300B may provide the status via an in-band or an out-of-band status channel of the optical fiber 200. In other embodiments, the optical receiver 300B may provide such characteristics via a separate optical fiber between the optical receiver 300B and the optical transmitter 100B and/or via a separate electrical communications link between the optical receiver 300B and the optical transmitter 100B. In yet other embodiments, the optical receiver 300B may simply detect power signal quality, a lack of a signal, and/or a data error rate and, based on such detected characteristics, may send a request to the optical transmitter 100B to use a different light source 124A-124N for subsequent transmissions. Again, the optical receiver 300B may make such a request via an in-band optical signal, an out-of-band optical signal, or an electrical signal.

Turning now to FIG. 2, implementation details of a first embodiment of the optical transmitter 100A, 100B are depicted. In particular, FIG. 2 depicts an embodiment comprising a plurality of light sources 124A, 124B, which are offset to either side of one or more first lenses 132 of the optical elements 130. Further, FIG. 2 depicts each light source 124A, 124B emitting a respective beam so that their respective light paths may be conveyed. However, during operation, the control circuitry 110 typically selects a single light source 124A, 124B to emit a beam. Thus, only a single beam is typically emitted at a given time.

Moreover, FIG. 2 depicts two light sources 124A, 124B and depicts each light source 124A, 124B with an associated two electrodes 125A1, 125A2, 125B1, 125B2. However, in other embodiments, the optical transmitter 100A, 100B may comprise a different quantity of light sources and/or a different quantity of electrodes associated with each light source.

As depicted, the one or more first lenses 132 may be integrated into a back side of the same semiconductor substrate 122 (*e.g.*, gallium arsenide (GaAs), indium phosphide (InP), gallium nitride (GaN), *etc*.) used to implement the light sources 124A, 124B. In such embodiments, the one or more first lenses 132 may be implemented as integrated refractive lenses, integrated diffractive lenses, angled lenses, and/or flat lenses on a back side surface of the semiconductor substrate 122. The one or more first lenses 132 may collimate a respective beam from whichever light source 124A, 124B has been selected to provide the optical signal and may direct the collimated beam to one or more second lenses 134. Moreover, the one or more first lenses 132 may angle the collimated beam towards the center of a fiber core 210 of the optical fiber 200 using angled surfaces, offset centers, or diffractive patterns.

The optical elements 130 may further include one or more second lenses 134. The one or more second lenses 134 may further focus, angle, or otherwise direct the beam into the fiber core 210 of the optical fiber 200. In various embodiments, the one or more second lenses 134 may be implemented using a second lens block 136 (*e.g.*, a glass block) that is separate from the semiconductor substrate 122 used to provide the light sources 124A, 124B and the one or more first lenses 132.

In various embodiments, an antireflective coating may be applied to one or more surfaces of the first lenses 132 and/or the second lenses 134. Such antireflective coatings may aid propagation of the optical signal or beam across interfaces that lie between media of differing refractive indices.

Moreover, in various embodiments, one or more of the first lenses 132 and/or one or more of the second lenses 134 may implement beam mode conditioning to enhance fiber launch characteristics and/or prevent back reflected light from interfering with the operation of the selected light source 124A, 124B.

As shown, the optical fiber 200 may include a fiber core 210 surround by a fiber cladding 220. In various embodiments, an end of the optical fiber 200 may be directly bonded to a surface or optical port 131 of the second lens block 136 so as receive the optical signal or beam provided by the selected light source 124A, 124B.

Referring now to FIG. 3, implementation details of a second embodiment of the optical transmitter 100A, 100B are depicts. In particular, FIG. 3 depicts an embodiment comprising a plurality of light sources 124A, 124B, which are offset to either side of one or more first lenses 132 of the optical elements 130. Further, FIG. 3 depicts each light sources 124A, 124B emitting a respective beam so that their respective light paths may be conveyed. However, during operation, the control circuitry 110 typically selects a single light source 124A, 124B to emit a beam. Thus, only a single beam is typically emitted at a given time.

Moreover, FIG. 3 depicts two light sources 124A, 124B and depicts each light source 124A, 124B with an associated two electrodes 125A1, 125A2, 125B1, 125B2. However, in other embodiments, the optical transmitter 100A, 100B may comprise a different quantity of light sources and/or a different quantity of electrodes associated with each light source.

As depicted, the one or more first lenses 132 may be provided by a separate first lens block 133 (*e.g.*, a glass block). In particular, the first lens block 133 may include one or more refractive lenses, one or more diffractive lenses, one or more angled lenses, and/or one or more flat lenses. The one or more first lenses 132 of the first lens block 133 may collimate the beam from whichever light source 124A, 124B has been selected to provide the optical signal and may focus the collimated beam directly into a fiber core 210 of the optical fiber 200. Moreover, the one or more first lenses 132 may angle the collimated beam towards the center of the fiber core 210 using angled surfaces, offset centers, or diffractive patterns. In some embodiments, the first lens block 133 may be bonded directly to a back side surface of the semiconductor substrate 122. In other embodiments, the first lens block 133 may be mechanically held in a position separated from the semiconductor substrate 122. In such embodiments, the first lens block 133 and its one or more first lenses 132 may receive the optical signal from the selected light source 124A, 124B via free space.

In various embodiments, an antireflective coating may be applied to one or more surfaces of the semiconductor substrate 122, the first lenses 132, and/or the optical fiber 200. Such antireflective coatings may aid propagation of the optical signal or beam across interfaces that lie between media of differing refractive indices.

Moreover, in various embodiments, one or more of the first lenses 132 may implement beam mode conditioning to enhance fiber launch characteristics and/or prevent back reflected light from interfering with the operation of the selected light source 124A, 124B.

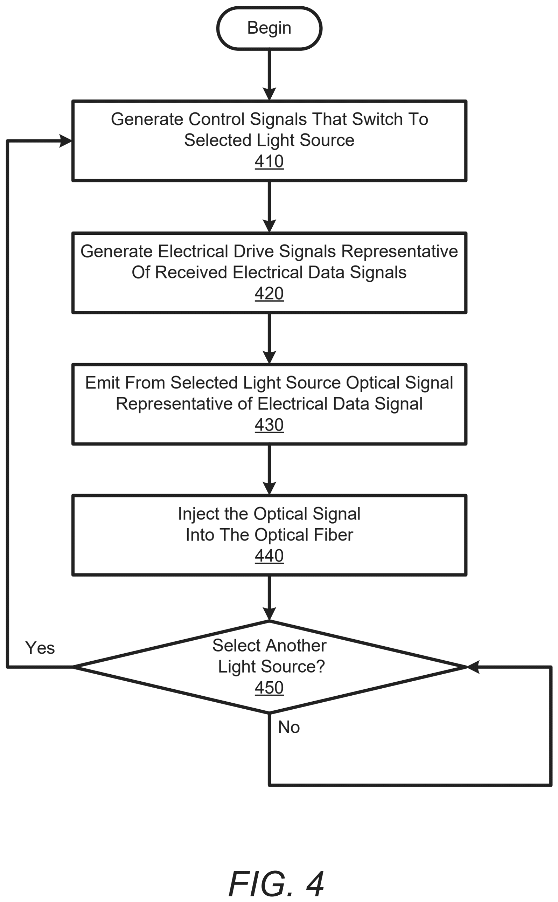

Referring now to FIG. 4, a sparing process 400 of the optical links 1A, 1B of FIG. 1A, 1B is depicted. At 410, the controller 116 may select one of the light sources 124A-124N for transmitting. To this end, the controller 116 may generate and provide one or more control signals to the switch 114. In response to such control signals, the switch 114 may couple the driver 112 to the selected light source 124A-124N.

At 420, the driver 112 may receive an electrical data signal and apply the electrical drive signal to electrodes of the selected light source 124A-124N. More specifically, the driver 112 may generate an electrical drive signal that is representative of the received electrical data signal and provide such electrical drive signal to the switch 114, which in turn directs the electrical drive signal to the electrodes for the selected light source 124A, 124N.

At 430, the selected light source 124A-124N may generate or emit an optical signal, per the electrical drive signal, that is representative of the electrical data signal received by the driver 112. At 440, the optical elements 130 may inject the emitted optical signal into the optical fiber 200 that is coupled to an optical port 131 of the optical transmitter 100A, 100B.

At 450, the controller 116 may determine, based on a received status signal, whether to select a different light source 124A-124N for transmission. In particular, the controller 116 of the optical transmitter 100A may receive such status signal from its optical sensor 140. The controller 116 of the optical transmitter 100B may receive such status signal from an external source such as the optical receiver 300B to which the optical transmitter 100B is transmitting the optical signal.

If the controller 116 at 450 determines to switch to another light source 124A-124N, the controller 116 may return to 410 in order to generate one or more control signals that cause the switch 114 to couple the driver 112 to the newly selected light source 124A-124N. Otherwise, the controller may return to 450 to continue to monitor the status of the selected light source 124A-124N via the received status signals.

The present disclosure includes reference to certain examples, however, it will be understood by those skilled in the art that various changes may be made and equivalents may be substituted without departing from the scope of the disclosure. In addition, modifications may be made to the disclosed examples without departing from the scope of the present disclosure. Therefore, it is intended that the present disclosure not be limited to the examples disclosed, but that the disclosure will include all examples falling within the scope of the appended claims.

Further aspects of the invention are described in the following clauses:
Clause 1. An optical transmitter, comprising:
   a plurality of light sources, wherein each light source is configured to generate an optical signal in response to being selected;
   one or more optical elements configured to inject an optical signal received from the plurality of light sources into an optical fiber coupled to an optical port of the one or more optical elements; and
   a controller configured to select a light source from the plurality of light sources and cause the selected light source to generate and provide its respective optical signal to the one or more optical elements for injection into the optical fiber.
Clause 2. The optical transmitter of clause 1, wherein each light source of the plurality of light sources is configured to not generate and provide its respective optical signal to the one or more optical elements when not selected by the controller.
Clause 3. The optical transmitter of clause 1, wherein the controller is configured to select a single light source from the plurality of light sources.
Clause 4. The optical transmitter of clause 1, wherein the controller, in response to a status signal representative of operation of the selected light source, selects a different light source from the plurality of light sources.
Clause 5. The optical transmitter of clause 1, wherein the controller selects a different light source from the plurality of light sources in response to a status signal indicating that the selected light source is not operating to specification.
Clause 6. The optical transmitter of clause 1, comprising:
   a driver configured to generate an electrical drive signal; and
   a switch configured to direct the electrical drive signal to the selected light source of the plurality of light sources.
Clause 7. The optical transmitter of clause 1, comprising a semiconductor light emitting device comprising a semiconductor substrate that is common to each light source of the plurality of light sources.
Clause 8. The optical transmitter of clause 7, wherein each light source originates its optical signal from a front side the semiconductor substrate.
Clause 9. The optical transmitter of clause 8, wherein the optical signal of each light surface passes through the semiconductor substrate and out a back side of the semiconductor substrate.
Clause 10. The optical transmitter of clause 9, wherein the one or more optical elements include one or more lenses integrated in the back side of the semiconductor substrate.
Clause 11. The optical transmitter of clause 9, wherein the one or more optical elements includes slanted surfaces along the back side of the semiconductor substrate.
Clause 12. The optical transmitter of clause 1, wherein the one or more optical elements includes a lens block configured to receive optical signals from the plurality of light sources and direct the received optical signals toward the optical port.
Clause 13. An optical link, comprising:
   an optical transmitter;
   an optical receiver; and
   an optical fiber coupled between the optical transmitter and the optical receiver;
   wherein the optical transmitter is configured to transmit an optical signal to the optical receiver via the optical fiber using a light source selected from a plurality of light sources;
   wherein the optical receiver is configured to monitor the optical signal received from the optical transmitter and provide the optical transmitter with a status signal that is representative of an operating characteristic of the selected light source used to transmit the optical signal; and
   wherein the optical transmitter is configured to select, based on the status signal, a different light source of the plurality of light sources for transmitting subsequent optical signals to the receiver via the optical fiber.
Clause 14. The optical link of clause 13, wherein the optical receiver is configured to provide the status signal to the optical transmitter via the optical fiber.
Clause 15. The optical link of clause 13, wherein the optical receiver is configured to provide the status signal to the optical transmitter via a second optical fiber.
Clause 16. The optical link of clause 13, wherein the optical receiver is configured to provide the status signal to the optical transmitter via an electrical signal.
Clause 17. The optical link of clause 13, wherein:
   the optical transmitter comprises a semiconductor light emitting device; and
   the semiconductor light emitting device comprises a semiconductor substrate that is common to each light source of the plurality of light sources.
Clause 18. The optical link of clause 17, wherein each light source originates its optical signal from a front side of the semiconductor substrate.
Clause 19. The optical link of clause 18, wherein the optical signal of each light surface passes through the semiconductor substrate and out a back side of the semiconductor substrate.
Clause 20. The optical link of clause 19, comprising one or more lenses integrated in the back side of the semiconductor substrate.

## Claims

1. An optical transmitter, comprising:
a plurality of light sources, wherein each light source is configured to generate an optical signal in response to being selected;
one or more optical elements configured to inject an optical signal received from the plurality of light sources into an optical fiber coupled to an optical port of the one or more optical elements; and
a controller configured to select a light source from the plurality of light sources and cause the selected light source to generate and provide its respective optical signal to the one or more optical elements for injection into the optical fiber.

2. The optical transmitter of claim 1, wherein each light source of the plurality of light sources is configured to not generate and provide its respective optical signal to the one or more optical elements when not selected by the controller.

3. The optical transmitter of claim 1, wherein the controller is configured to select a single light source from the plurality of light sources.

4. The optical transmitter of claim 1, wherein the controller, in response to a status signal representative of operation of the selected light source, selects a different light source from the plurality of light sources.

5. The optical transmitter of claim 1, wherein the controller selects a different light source from the plurality of light sources in response to a status signal indicating that the selected light source is not operating to specification.

6. The optical transmitter of claim 1, comprising:
a driver configured to generate an electrical drive signal; and
a switch configured to direct the electrical drive signal to the selected light source of the plurality of light sources.

7. The optical transmitter of claim 1, comprising a semiconductor light emitting device comprising a semiconductor substrate that is common to each light source of the plurality of light sources.

8. The optical transmitter of claim 7, wherein each light source originates its optical signal from a front side the semiconductor substrate.

9. The optical transmitter of claim 8, wherein the optical signal of each light surface passes through the semiconductor substrate and out a back side of the semiconductor substrate.

10. The optical transmitter of claim 9, wherein the one or more optical elements include one or more lenses integrated in the back side of the semiconductor substrate or slanted surfaces along the back side of the semiconductor substrate.

11. The optical transmitter of claim 1, wherein the one or more optical elements includes a lens block configured to receive optical signals from the plurality of light sources and direct the received optical signals toward the optical port.

12. An optical link, comprising:
an optical transmitter;
an optical receiver; and
an optical fiber coupled between the optical transmitter and the optical receiver;
wherein the optical transmitter is configured to transmit an optical signal to the optical receiver via the optical fiber using a light source selected from a plurality of light sources;
wherein the optical receiver is configured to monitor the optical signal received from the optical transmitter and provide the optical transmitter with a status signal that is representative of an operating characteristic of the selected light source used to transmit the optical signal; and
wherein the optical transmitter is configured to select, based on the status signal, a different light source of the plurality of light sources for transmitting subsequent optical signals to the receiver via the optical fiber.

13. The optical link of claim 12, wherein the optical receiver is configured to provide the status signal to the optical transmitter via the optical fiber or via a second optical fiber or via an electrical signal.

14. The optical link of claim 12, wherein:
the optical transmitter comprises a semiconductor light emitting device; and
the semiconductor light emitting device comprises a semiconductor substrate that is common to each light source of the plurality of light sources.

15. The optical link of claim 14, wherein each light source originates its optical signal from a front side of the semiconductor substrate and wherein, preferably, the optical signal of each light surface passes through the semiconductor substrate and out a back side of the semiconductor substrate, the optical link preferably comprising one or more lenses integrated in the back side of the semiconductor substrate.
